# FASCICULE DE BREVET EUROPEEN

(11) **EP 2 989 656 B1**
(45) Date de publication et mention de la délivrance du brevet: **22.02.2017**
(21) Numéro de dépôt: 14722295.4
(22) Date de dépôt: 18.04.2014
(51) Int. Cl.: H01L 21/285, H01L 29/47, H01L 29/16

(54) **PROCÉDÉ DE FABRICATION D'UNE DIODE SCHOTTKY SUR UN SUBSTRAT EN DIAMANT**
VERFAHREN ZUR HERSTELLUNG EINER SCHOTTKY-DIODE AUF EINEM DIAMANTSUBSTRAT
METHOD FOR PRODUCING A SCHOTTKY DIODE ON A DIAMOND SUBSTRATE

(30) Priorité: 22.04.2013 FR 1353647
(43) Date de publication de la demande: 02.03.2016
(73) Titulaire: Centre National de la Recherche Scientifique, 75794 Paris Cedex 16 (FR); Université Grenoble Alpes, 38400 Saint-Martin-d'Hères (FR); Institut Polytechnique de Grenoble, 38000 Grenoble (FR)
(72) Inventeur: EON, David, F-38400 Saint Martin d'Hères (FR); GHEERAERT, Etienne, F-38360 Sassenage (FR); MURET, Pierre, F-38410 Saint Martin d'Uriage (FR); PERNOT, Julien, F-38000 Grenoble (FR); TRAORE, Aboulaye, F-38100 Grenoble (FR)
(74) Mandataire: Thibon, Laurent
(86) Numéro de dépôt international: PCT/FR2014/050952
(87) Numéro de publication internationale: WO 2014/174192

(56) Documents cités:
- JP-A- H0 922 880
- JP-A- 2007 095 794
- US-A1- 2010 090 226
- US-A1- 2012 091 453
- BAUMANN P K ET AL: "Electron affinity and Schottky barrier height of metal-diamond (100), (111), and (110) interfaces", JOURNAL OF APPLIED PHYSICS, AMERICAN INSTITUTE OF PHYSICS, 2 HUNTINGTON QUADRANGLE, MELVILLE, NY 11747, vol. 83, no. 4, 15 février 1998 (1998-02-15), pages 2072-2082, XP012044685, ISSN: 0021-8979, DOI: 10.1063/1.366940
- TERAJI T ET AL: "Low-leakage p-type diamond Schottky diodes prepared using vacuum ultraviolet light/ozone treatment", JOURNAL OF APPLIED PHYSICS, AMERICAN INSTITUTE OF PHYSICS, 2 HUNTINGTON QUADRANGLE, MELVILLE, NY 11747, vol. 105, no. 12, 25 juin 2009 (2009-06-25), pages 126109-126109, XP012125805, ISSN: 0021-8979, DOI: 10.1063/1.3153986 cité dans la demande

## Description

La présente demande de brevet revendique la priorité de la demande de brevet français FR13/53647 qui sera considérée comme faisant partie intégrante de la présente description.

### Domaine

La présente demande concerne la réalisation de composants électroniques dans et sur des substrats en diamant monocristallin. Elle vise plus particulièrement la réalisation d'une diode Schottky comprenant un contact Schottky entre une couche semiconductrice en diamant monocristallin et une couche conductrice.

### Exposé de l'art antérieur

On a déjà proposé dans la littérature, de réaliser des composants électroniques, et notamment des diodes Schottky, en utilisant du diamant monocristallin dopé comme matériau semiconducteur. Le diamant présente en effet des propriétés physiques et électroniques qui le rendent particulièrement attractif, notamment pour des applications de forte puissance.

Toutefois, en pratique, une limitation majeure à l'utilisation de diodes Schottky au diamant est que, à ce jour, les procédés de fabrications connus ne permettent pas d'obtenir des diodes ayant des performances électriques suffisamment élevées, stables et reproductibles pour une utilisation industrielle La publication de P. Baumann et al. intitulée "Electron affinity and Schottky barrier height of metal-diamond (100), (111), and (110) interfaces", parue au Journal of Applied Physics 83(4), 2072 (1998), décrit un procédé de fabrication d'un contact Schottky sur un substrat de diamant, comportant une étape d'oxygénation de la surface du substrat et le dépôt d'une couche de zirconium. .

### Résumé

Ainsi, un objet d'un mode de réalisation est de prévoir un procédé de fabrication d'une diode Schottky au diamant, ce procédé palliant tout ou partie des inconvénients des procédés connus.

Ainsi, un mode de réalisation prévoit un procédé de fabrication d'une diode Schottky, comportant les étapes suivante : a) oxygéner la surface d'une couche semiconductrice en diamant monocristallin, de façon à remplacer des terminaisons de surface hydrogène de la couche semiconductrice par des terminaisons de surface oxygène ; et b) former, par dépôt physique en phase vapeur, une première couche conductrice d'oxyde d'indium-étain à la surface de la couche semiconductrice.

Selon un mode de réalisation, à l'étape a), la couche semiconductrice est placée dans une enceinte contenant du dioxygène à une pression inférieure à la pression atmosphérique, et est irradiée par une lumière ultraviolette.

Selon un mode de réalisation, la première couche conductrice est une couche d'oxyde d'indium-étain et est formée, à l'étape b), par pulvérisation d'une cible d'oxyde d'indium-étain.

Selon un mode de réalisation, à l'étape b), la couche semiconductrice et la cible d'oxyde d'indium-étain sont placées dans une enceinte contenant un plasma à l'argon.

Selon un mode de réalisation, le procédé comprend en outre, après l'étape b), un recuit de recristallisation de la couche d'oxyde d'indium-étain à une température comprise entre 100 et 300°C.

Selon un mode de réalisation, le procédé comprend en outre, après l'étape b), le dépôt d'au moins une deuxième couche conductrice à la surface de la première couche conductrice, les couches conductrices formant ensemble une électrode de la diode Schottky.

Selon un mode de réalisation, la deuxième couche conductrice comprend une couche d'or.

Selon un mode de réalisation, la couche semiconductrice est dopée de type P.

Selon un mode de réalisation, la couche semiconductrice est formée par épitaxie sur une couche semiconductrice en diamant monocristallin de même type de conductivité mais plus fortement dopée.

Selon un mode de réalisation, le procédé comporte en outre la formation d'une électrode formant un contact ohmique avec la couche plus fortement dopée.

Selon un mode de réalisation, l'épaisseur de la première couche conductrice déposée à l'étape b) est comprise entre 20 et 30 nm.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
les figures 1A à 1D sont des vues en coupe illustrant de façon schématique des étapes d'un exemple d'un mode de réalisation d'un procédé de fabrication d'une diode Schottky comprenant un contact Schottky entre une couche semiconductrice en diamant monocristallin et une couche conductrice ;
la figure 2 est une vue de dessus de la structure de la figure 1D ; et
les figures 3 et 4 sont des diagrammes illustrant des caractéristiques électriques de fonctionnement d'une diode Schottky réalisée par le procédé des figures 1A à 1D.

Par souci de clarté, de mêmes éléments ont été désignés par de mêmes références aux différentes figures et, de plus, comme cela est habituel dans la représentation des circuits intégrés, les diverses figures ne sont pas tracées à l'échelle.

### Description détaillée

Dans la suite de la description, sauf indication contraire, les termes "approximativement", "sensiblement", "environ" et "de l'ordre de" signifient "à 10 % près".

Jusqu'à présent, toutes les tentatives menées par les acteurs du domaine des composants électroniques en diamant pour obtenir une diode Schottky au diamant présentant à la fois une tenue en tension inverse élevée, par exemple supérieure à 100 volts, et une forte densité de courant à l'état passant, par exemple supérieure à 500 A/cm² sous 7 volts à température ambiante, se sont soldées par des échecs.

De plus, les procédés de fabrication connus posent d'autres problèmes qui les rendent inadaptés à la fabrication à échelle industrielle de diodes Schottky au diamant. En particulier, les procédés connus posent des problèmes de reproductibilité, c'est-à-dire que l'on observe d'importants écarts de performances électriques, liés à des écarts de fabrication, entre des diodes distinctes réalisées par un même procédé. En outre, les diodes obtenues par les procédés connus présentent des problèmes de stabilité en température, c'est-à-dire que l'on observe d'importants écarts de performances électriques lorsque la température varie. De plus, lorsque la température de la diode dépasse une certaine température, par exemple de l'ordre de 250°C, on peut observer une dégradation irréversible de la jonction Schottky. Ceci est particulièrement gênant dans les applications de forte puissance dans lesquelles un échauffement important de la diode peut se produire lorsque la diode conduit.

Des études menées par les inventeurs semblent montrer que les états de surface à l'interface entre le matériau conducteur de la jonction Schottky et le diamant semiconducteur, pourraient être à l'origine de tout ou partie des problèmes susmentionnés.

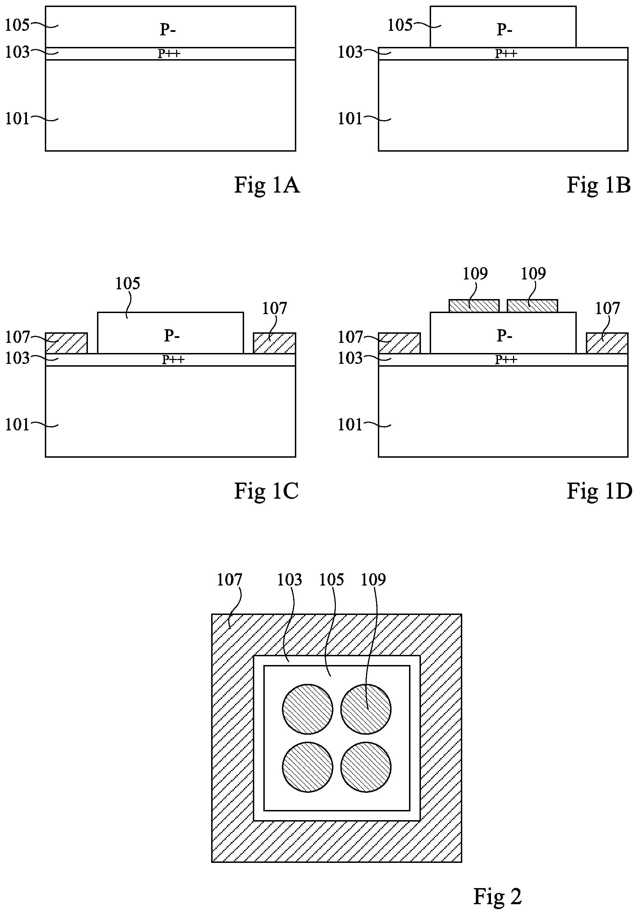

Les figures 1A à 1D sont des vues en coupe illustrant de façon schématique des étapes d'un exemple de mode de réalisation d'un procédé de fabrication d'une diode Schottky comprenant un contact Schottky entre une couche semiconductrice en diamant et une couche conductrice.

La figure 1A illustre une structure de départ comportant un substrat 101 en diamant monocristallin revêtu d'une couche épitaxiée 103 de diamant fortement dopé de type P (P++). La couche 103 est elle-même revêtue d'une couche épitaxiée 105 de diamant faiblement dopé de type P (P-). Le substrat 101 est par exemple en diamant naturel taillé, ou en diamant synthétique obtenu par croissance à haute pression et haute température, par dépôt chimique en phase vapeur, ou par toute autre technique connue. L'épaisseur du substrat 101 est par exemple comprise entre 300 et 700 µm, par exemple de l'ordre de 500 µm. Les couches épitaxiées 103 et 105 sont par exemple obtenues par des étapes de dépôt chimique en phase vapeur assisté par plasma en présence d'un rayonnement micro-ondes, selon une méthode désignée dans la technique par le sigle MPCVD, de l'anglais "Microwave Plasma Chemical Vapor Déposition". Les couches 103 et 105 sont par exemple dopées au bore. A titre d'exemple, la couche 103 contient du bore à une concentration comprise entre 10¹⁹ et 10²¹ atomes/cm³, par exemple de l'ordre de 5x10²⁰ atomes/cm³, et la couche 105 contient du bore à une concentration comprise entre 10¹⁴ et 10¹⁶ atomes/cm3, par exemple de l'ordre de 10¹⁵ atomes/cm3. A titre d'exemple, la couche 103 a une épaisseur comprise entre 100 et 300 nm, par exemple de l'ordre de 200 nm, et la couche 105 a une épaisseur comprise entre 500 nm et 50 µm, par exemple de l'ordre de 1300 nm. Pour obtenir une tenue en tension relativement élevée, une couche 105 d'épaisseur comprise entre 3 et 15 µm peut être prévue. La surface, en vue de dessus, du substrat 101 et des couches 103 et 105, est par exemple de l'ordre quelques millimètres carrés. Dans cet exemple, le substrat 101 et les couches 103 et 105 ont, en vue de dessus, la forme d'un carré d'environ 3 mm de côté.

La figure 1B illustre une étape de gravure d'une partie de la couche P- 105. Dans cet exemple, une partie périphérique de la couche 105, par exemple une bande périphérique de largeur de l'ordre de 1 mm en vue de dessus, est retirée par gravure de façon à rendre accessible une partie de la face supérieure (dans l'orientation des figures) de la couche 103. La gravure est par exemple une gravure ionique réalisée à l'aide d'un plasma à l'oxygène généré par un champ électromagnétique radio fréquence, selon une méthode désignée dans la technique par le sigle ICP-RIE, de l'anglais "Inductively Coupled Plasma - Reactive Ion Etching". Toutefois, toute autre technique connue peut être utilisée pour graver la couche 105. Dans cet exemple, à l'issue de l'étape de gravure, la partie restante de la couche 105 a, en vue de dessus, la forme d'un carré d'approximativement 2 mm de côté disposé au centre de la couche 103.

La figure 1C illustre une étape de réalisation d'une électrode 107 revêtant la partie de la couche P++ 103 non revêtue par la couche 105, cette électrode formant un contact ohmique avec la couche 103. L'électrode 107 forme l'anode de la diode Schottky, et est reliée électriquement à la face inférieure (dans l'orientation des figures) de la couche 105 par l'intermédiaire de la couche P++ 103 (on parle généralement de diode Schottky pseudo-verticale pour désigner ce type de structure).

A titre d'exemple, l'électrode 107 comprend un empilement comprenant, dans l'ordre à partir de la surface de la couche 103, une couche de titane d'environ 30 nm d'épaisseur, une couche de platine d'environ 50 nm d'épaisseur, et une couche d'or d'environ 40 nm d'épaisseur. Par souci de simplification, les différentes couches de l'empilement n'ont pas été représentées sur les figures. Les couches de titane, de platine et d'or peuvent être déposées en plusieurs étapes successives, par exemple par dépôt physique en phase vapeur sous vide, selon une méthode désignée dans la technique par le sigle EBPVD, de l'anglais "Electron Beam Physical Vapor Déposition". Après les dépôts métalliques successifs, un recuit à une température supérieure à 450°C, par exemple à une température de l'ordre de 750°C pendant environ 30 minutes, peut être prévu. Dans cet exemple, lors du recuit, du carbure de titane se forme à l'interface entre la couche 103 et l'électrode 107, ce qui permet non seulement de créer un contact ohmique entre l'électrode 107 et la couche de diamant 103, mais aussi d'assurer l'adhérence de l'électrode 107 sur la couche 103. D'autres matériaux, d'autres épaisseurs, et/ou d'autres procédés de fabrication pourront toutefois être utilisés pour réaliser l'électrode 107. On notera qu'un masque (non visible sur les figures), par exemple en résine, peut être formé préalablement au dépôt de l'électrode 107, pour délimiter la forme, en vue de dessus, de l'électrode 107. Dans l'exemple représenté, un mince espace, par exemple de l'ordre de quelques µm de largeur en vue de dessus, sépare l'électrode 107 de la couche P- 105, de façon à ce que l'électrode 107 ne soit pas directement en contact avec la couche 105.

Avant de déposer, sur la surface supérieure (dans l'orientation des figures) de la couche semiconductrice 105, une couche conductrice formant un contact Schottky avec la couche 105, on prévoit une étape d'oxygénation de la surface supérieure de la couche 105. A titre d'exemple, après la formation de l'électrode 107, la structure est placée dans une enceinte sous vide, puis on introduit de l'oxygène dans l'enceinte, et la surface supérieure de la couche 105 est irradiée par un rayonnement ultraviolet. Ceci conduit à remplacer les terminaisons hydrogène de la surface supérieure de la couche de diamant 105 par des terminaisons oxygène. Un tel procédé d'oxygénation du diamant, connu en lui-même, est par exemple décrit dans l'article de T. Teraji et al, paru au Journal of Applied Physics 105, 126109 (2009*).* On notera que, par enceinte sous vide, on entend ici une enceinte dans laquelle la pression est inférieure à la pression atmosphérique, par exemple de l'ordre de 10⁻⁵ millibars. Lorsque l'oxygène est présent dans l'enceinte, la pression dans l'enceinte est par exemple de l'ordre de 0,4 millibars. A titre d'exemple, la durée d'exposition de la structure à l'oxygène et au rayonnement ultraviolet est comprise entre 1 heure et 3 heures. L'étape d'oxygénation se fait par exemple à température ambiante.

Plus généralement, tout autre procédé apte à remplacer des terminaisons de surface hydrogène du diamant par des terminaisons de surface oxygène pourra être utilisé, par exemple un procédé d'oxygénation par plasma.

On notera que le diamant monocristallin présente l'avantage que ses terminaisons de surface, qu'elles soient hydrogène ou oxygène, sont très stables une fois modifiées. Le transfert du substrat d'une enceinte à une autre lors des différentes étapes de procédé ne pose donc pas de problème particulier.

La figure 1D illustre une étape de formation d'une électrode conductrice 109 sur la surface supérieure de la couche de diamant dopé (P-) 105, formant un contact Schottky avec la couche 105. La figure 2 est une vue de dessus de la structure de la figure 1D.

Un masque, non visible sur les figures, par exemple en résine, peut être formé préalablement au dépôt de l'électrode 109, pour délimiter la forme, en vue de dessus, de l'électrode 109. Après l'ouverture du masque au niveau de la zone de dépôt de l'électrode 109 sur la couche 105, une étape de nettoyage de la zone de dépôt est de préférence prévue pour éliminer tout résidu de résine susceptible de se trouver sur la surface de la couche 105. A titre d'exemple, ce nettoyage est mis en oeuvre par gravure ionique, à l'aide d'un plasma oxygène généré par un champ électromagnétique radio fréquence, selon une méthode désignée dans la technique par le sigle CCP-RIE, de l'anglais "Capacitively Coupled Plasma - Reactive Ion Etching". La zone de dépôt de l'électrode 109 est par exemple exposée au plasma de gravure pendant une durée d'environ 30 secondes. Toute autre méthode de nettoyage connue peut toutefois être utilisée à la place ou en complément de la méthode de nettoyage susmentionnée.

Dans l'exemple représenté, l'électrode 109, ou cathode de la diode Schottky, comprend quatre sous-électrodes disjointes approximativement circulaires en vue de dessus, ce qui revient en fait à former une structure comportant quatre diodes Schottky à anode commune (électrode 107). Bien entendu, d'autres dispositions de l'électrode 109 peuvent être prévues en fonction de l'utilisation envisagée (par exemple une unique électrode 109 continue revêtant toute la surface de la couche 105).

Selon un premier aspect, ne faisant pas partie de la présente invention, l'électrode 109 comprend une mince couche de zirconium, déposée à la surface de la couche de diamant 105 et formant un contact Schottky ou contact redresseur avec la couche 105. La couche de zirconium est formée par dépôt physique en phase vapeur sous vide, selon une méthode désignée dans la technique par le sigle EBPVD, de l'anglais "Electron Beam Physical Vapor Déposition". Pour cela, la structure est placée dans une chambre sous vide contenant une cible de zirconium, et la cible est bombardée avec un faisceau d'électrons. Le faisceau d'électrons arrache ou évapore des atomes de zirconium de la cible - on parle aussi d'évaporation de la cible. Les atomes de zirconium vaporisés précipitent ou s'adsorbent alors sous forme solide, recouvrant la surface de la structure d'une mince couche de zirconium. On notera que, par chambre sous vide, on entend ici une enceinte dans laquelle la pression est inférieure à la pression atmosphérique, par exemple de l'ordre de 10⁻⁶ à 10⁻⁸ millibars et de préférence de l'ordre de 10⁻⁷ millibars, de préférence sous atmosphère non oxygénée. Le dépôt est par exemple effectué à température ambiante. La vitesse de dépôt du zirconium sur la surface supérieure de la couche de diamant 105 est par exemple de l'ordre de 0,1 nm par seconde. L'épaisseur de la couche de zirconium déposée est par exemple de l'ordre de 10 à 50 nm, et de préférence de l'ordre de 20 à 30 nm.

L'électrode 109 peut en outre comprendre un ou plusieurs autres matériaux conducteurs revêtant la surface de la couche de zirconium opposée à la couche de diamant 105. Par souci de simplification, les différentes couches de l'électrode 109 n'ont pas été différenciées sur les figures. A titre d'exemple, la couche de zirconium peut être revêtue d'une couche d'or ayant notamment pour rôle d'éviter l'oxydation du zirconium et d'épaissir l'électrode. A titre de variante, une couche barrière de platine, par exemple d'environ 20 à 40 nm d'épaisseur, peut être déposée entre la couche de zirconium et la couche d'or, la couche de platine ayant notamment pour rôle d'éviter la diffusion de l'or dans le zirconium, ce qui permet notamment à la diode de supporter sans dégradation des températures élevées, par exemple de l'ordre de 400°C voire plus. A titre de variante, l'électrode 109 peut comprendre une couche de nickel, par exemple de l'ordre de 100 à 300 nm d'épaisseur, entre la couche de platine et la couche d'or, cette couche de nickel ayant notamment pour rôle d'épaissir l'électrode.

Après la formation de la couche de zirconium (avant ou après la formation d'éventuelles couches conductrices supérieures de l'électrode 109), un recuit peut être prévu, par exemple à une température comprise entre 300 et 500°C, pour améliorer encore la qualité de l'interface zirconium/diamant formant la jonction Schottky de la diode.

Selon un deuxième aspect selon la présente invention, l'électrode 109 comprend une mince couche conductrice en oxyde d'indium-étain, généralement désigné dans la technique par le sigle ITO, déposée à la surface de la couche de diamant 105 et formant un contact Schottky ou contact redresseur avec la couche. La couche d'ITO est formée par pulvérisation cathodique, par exemple sous argon. Pour cela, la structure est placée dans une chambre contenant une cible d'ITO, et la cible est bombardée à l'aide d'un plasma contenant des atomes lourds, par exemple de l'argon, et ne contenant de préférence pas d'oxygène. Le plasma arrache ou pulvérise des atomes de la cible d'ITO. Ces atomes se déposent alors sur la surface de la structure, la revêtant d'une mince couche d'ITO. Le dépôt d'ITO est par exemple effectué à température ambiante. L'épaisseur de la couche d'ITO déposée est par exemple de l'ordre de 10 à 50 nm, et de préférence de l'ordre de 20 à 30 nm. Après le dépôt, un recuit de recristallisation de l'ITO est de préférence prévu, par exemple à une température de l'ordre de 100 à 300°C et de préférence à une température de l'ordre de 200°C. La durée du recuit de recristallisation est par exemple comprise entre 15 et 60 minutes, par exemple d'environ 30 minutes. Le recuit de recristallisation se fait par exemple sous atmosphère non modifiée (air).

L'électrode 109 peut en outre comprendre un ou plusieurs autres matériaux conducteurs revêtant la surface de la couche d'ITO opposée à la couche de diamant 105. Par souci de simplification, les différentes couches de l'électrode 109 n'ont pas été différenciées sur les figures. A titre d'exemple, la couche d'ITO peut être revêtue d'une couche protectrice d'or de 10 à 20 nm d'épaisseur ou plus.

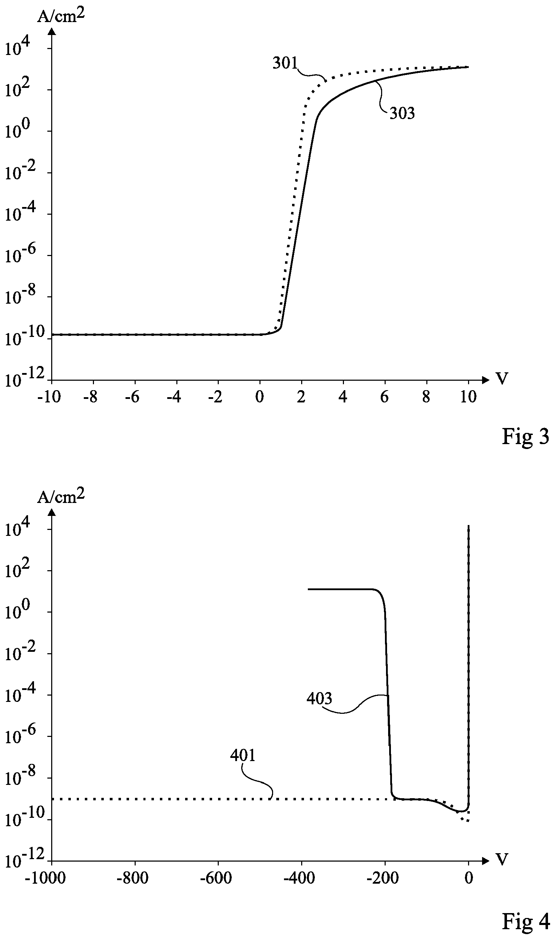

Comme cela apparaît sur les figures 3 et 4 qui seront décrites plus en détail ci-après, une caractéristique importante et avantageuse des diodes Schottky réalisées par le procédé des figures 1A à 1D, qu'elles soient réalisées avec une jonction Schottky zirconium/diamant ou avec une jonction Schottky ITO/diamant, est qu'elles présentent à la fois une tenue en tension en inverse élevée et une forte densité de courant à l'état passant (c'est-à-dire une bonne conductivité en direct), ce qui n'avait jamais été observé auparavant pour des diodes Schottky au diamant.

Ces caractéristiques ont pu être obtenues grâce à la qualité de l'interface entre la couche conductrice et la couche semiconductrice en diamant de la jonction Schottky, obtenue en combinant l'utilisation d'une étape d'oxygénation des terminaisons de surface de la couche de diamant 105, préalablement à la formation de la couche conductrice, et l'utilisation d'un dépôt de zirconium par évaporation par canon à électrons ou d'un dépôt d'ITO par pulvérisation cathodique, pour former la couche conductrice.

La figure 3 est un diagramme représentant l'évolution de la densité de courant, en A/cm², circulant dans une diode Schottky réalisée par le procédé des figures 1A à 1D, en fonction de la tension, en volts (V), appliquée entre l'anode (électrode 107) et la cathode (électrode 109) de la diode, au voisinage de la tension de seuil (tension de mise en conduction en direct) de la diode. La courbe 301, en pointillés sur la figure 3, correspond à une diode zirconium/diamant, et la courbe 303, en trait plein sur la figure 3, correspond à une diode ITO/diamant.

La figure 4 est un diagramme représentant l'évolution de la densité de courant, en A/cm², circulant dans une diode Schottky réalisée par le procédé des figures 1A à 1D, en fonction de la tension, en volts (V), appliquée entre l'anode et la cathode de la diode, au voisinage de la tension de claquage en inverse de la diode. La courbe 401, en pointillés sur la figure 4, correspond à une diode zirconium/diamant, et la courbe 403, en trait plein sur la figure 4, correspond à une diode ITO/diamant.

Pour une diode zirconium/diamant, les inventeurs ont mesuré, à température ambiante (de l'ordre de 27°C), une densité de courant de l'ordre de 1000 A/cm² sous 7 V dans le mode passant (courbe 301), et une tension de claquage en inverse supérieure à 1000 V (courbe 401). On notera que les mesures effectuées n'ont pas permis de déterminer la valeur exacte de la tension de claquage mais ont montré que la tension de claquage était supérieure à 1000 V.

Pour une diode ITO/diamant, les inventeurs ont mesuré, à température ambiante, une densité de courant de l'ordre de 640 A/cm² sous 7 V dans le mode passant (courbe 303), et une tension de claquage en inverse de l'ordre de 200 V (courbe 403).

Par ailleurs, les inventeurs ont constaté que dans le mode bloqué, les courants de fuite dans la diode sont extrêmement faibles, typiquement inférieurs à 10⁻⁹ A/cm² jusqu'au voisinage de la tension de claquage pour une diode ITO/diamant (courbes 303 et 403), et inférieurs à 10⁻⁹ A/cm² jusqu'à au moins 1000 V pour une diode zirconium/diamant (courbes 301 et 401).

Les inventeurs ont en outre déterminé que pour une diode zirconium/diamant dans laquelle l'électrode 109 comprend en outre une couche de platine revêtant la couche de zirconium et une couche d'or revêtant la couche de platine, la hauteur de barrière, en électron volt (eV), entre la couche de diamant 105 et la couche de zirconium, est de l'ordre de :
1,97 eV, ce qui se traduit par une tension de seuil d'environ 2,35 V pour un courant de 1 mA et une densité de courant de 12,74 A/cm², si le dépôt de la couche de zirconium n'est pas suivi d'un recuit ;
1,4 eV, ce qui se traduit par une tension de seuil d'environ 1,95 V pour un courant de 1 mA et une densité de courant de 12,74 A/cm², si le dépôt de la couche de zirconium est suivi d'un recuit à une température de l'ordre de 350°C ; et
1 eV, ce qui se traduit par une tension de seuil d'environ 1,1 V pour un courant de 1 mA et une densité de courant de 12,74 A/cm², si le dépôt de la couche de zirconium est suivi d'un recuit à une température de l'ordre de 450°C.

Ainsi, la prévision d'un recuit après le dépôt de la couche de zirconium permet d'abaisser la hauteur de barrière de la jonction Schottky, et donc de réduire les pertes à l'état passant. De plus, un tel recuit permet d'améliorer la stabilité thermique de la diode.

Un autre avantage du procédé des figures 1A à 1D est que les caractéristiques électriques des diodes Schottky obtenues sont parfaitement reproductibles d'une diode à une autre.

Un autre avantage du procédé des figures 1A à 1D est qu'il permet d'obtenir des diodes Schottky présentant des performances stables en température, et résistant, sans dégradation, à des températures élevées, typiquement de l'ordre de 400°C ou plus.

Il résulte de ce qui précède que le procédé des figures 1A à 1D est compatible avec la réalisation de diodes Schottky au diamant pour une utilisation à l'échelle industrielle.

Des modes de réalisation particuliers ont été décrits. Diverses variantes et modifications apparaîtront à l'homme de l'art. En particulier, bien que le procédé proposé ait été décrit en relation avec un exemple de réalisation d'une diode Schottky à structure pseudo-verticale, les modes de réalisation décrits ne se limitent pas à ce cas particulier. L'homme de l'art saura utiliser le procédé proposé pour réaliser des diodes Schottky ayant d'autres structures, par exemple une structure réellement verticale, dans laquelle l'électrode d'anode 107 est disposée du côté de la couche 105 opposé à l'électrode 109.

De plus, bien que le procédé proposé ait été décrit dans le cas où la couche semiconductrice en diamant de la jonction Schottky est de type P, l'homme de l'art saura adapter le procédé proposé à la réalisation d'une diode Schottky au diamant dans laquelle la couche semiconductrice en diamant de la jonction Schottky est de type N.

## Revendications

1. Procédé de fabrication d'une diode Schottky, comportant les étapes suivantes :
a) oxygéner la surface d'une couche semiconductrice (105) en diamant monocristallin, de façon à remplacer des terminaisons de surface hydrogène de la couche semiconductrice (105) par des terminaisons de surface oxygène ; et
b) former, par dépôt physique en phase vapeur, une première couche conductrice d'oxyde d'indium-étain à la surface de la couche semiconductrice (105).

2. Procédé selon la revendication 1, dans lequel, à l'étape a), la couche semiconductrice (105) est placée dans une enceinte contenant du dioxygène à une pression inférieure à la pression atmosphérique, et est irradiée par une lumière ultraviolette.

3. Procédé selon la revendication 1 ou 2, dans lequel la première couche conductrice est formée, à l'étape b), par pulvérisation d'une cible d'oxyde d'indium-étain.

4. Procédé selon la revendication 3, dans lequel, à l'étape b), la couche semiconductrice (105) et la cible d'oxyde d'indium-étain sont placées dans une enceinte contenant un plasma à l'argon.

5. Procédé selon la revendication 3 ou 4, comprenant en outre, après l'étape b), un recuit de recristallisation de la couche d'oxyde d'indium-étain à une température comprise entre 100 et 300°C.

6. Procédé selon l'une quelconque des revendications 1 à 5, comprenant en outre, après l'étape b), le dépôt d'au moins une deuxième couche conductrice à la surface de la première couche conductrice, lesdites couches conductrices formant ensemble une électrode (109) de la diode Schottky.

7. Procédé selon la revendication 6, dans lequel ladite au moins une deuxième couche conductrice comprend une couche d'or.

8. Procédé selon l'une quelconque des revendications 1 à 7, dans lequel la couche semiconductrice (105) est dopée de type P.

9. Procédé selon l'une quelconque des revendications 1 à 8, dans lequel la couche semiconductrice (105) est formée par épitaxie sur une couche semiconductrice (103) en diamant monocristallin de même type de conductivité mais plus fortement dopée.

10. Procédé selon la revendication 9, comportant en outre la formation d'une électrode (107) formant un contact ohmique avec ladite couche (103) plus fortement dopée.

11. Procédé selon l'une quelconque des revendications 1 à 10, dans lequel l'épaisseur de la première couche conductrice déposée à l'étape b) est comprise entre 20 et 30 nm.

## Patentansprüche

1. Ein Verfahren zur Herstellung einer Schottky Diode, wobei das Verfahren die folgenden Schritte aufweist:
a) Oxygenisieren der Oberfläche einer Einkristall-Diamanthalbleiterschicht (105), um Wasserstoff-Oberflächenabschlüsse der Halbleiterschicht (105) durch Sauerstoff-Oberflächenabschlüsse zu ersetzen; und
b) Ausbilden, durch physikalisches Abscheiden aus der Dampfphase, einer ersten Indium-Zinnoxid leitenden Schicht an der Oberfläche der Halbleiterschicht (105).

2. Das Verfahren nach Anspruch 1, wobei im Schritt a), die Halbleiterschicht (105) in eine Kammer eingebracht wird, die Sauerstoff bei einem Druck aufweist, der niedriger ist als der atmosphärische Druck, und mit ultraviolettem Licht bestrahlt wird.

3. Das Verfahren nach Anspruch 1 oder 2, wobei die erste leitende Schicht im Schritt b) ausgebildet wird durch Sputtern eines Indium-Zinnoxid Ziels oder Targets.

4. Das Verfahren nach Anspruch 3, wobei im Schritt b) die Halbleiterschicht (105) und das Indium-Zinnoxid Target in eine Kammer eingebracht sind, die ein Argonplasma enthält.

5. Das Verfahren nach Anspruch 3 oder 4, wobei das Verfahren ferner nach Schritt b) Folgendes aufweist: ein Tempern bzw. Annealen zur Re-kristallisierung der Indium-Zinnoxidschicht bei einer Temperatur in einem Bereich von 100 bis 300°C.

6. Das Verfahren nach einem der Ansprüche 1 bis 5, wobei das Verfahren ferner nach Schritt b) den Schritt des Abscheidens von wenigstens einer zweiten leitenden Schicht auf der Oberfläche der ersten leitenden Schicht aufweist, wobei diese leitenden Schichten zusammen eine Elektrode (109) der Schottky Diode bilden.

7. Das Verfahren nach Anspruch 6, wobei die wenigstens eine zweite leitende Schicht eine Goldschicht aufweist.

8. Das Verfahren nach einem der Ansprüche 1 bis 7, wobei die Halbleiterschicht (105) eine P-Typ dotierte Schicht ist.

9. Das Verfahren nach einem der Ansprüche 1 bis 8, wobei die Halbleiterschicht (105) durch Aufwachsen auf einer Einkristall-Diamanthalbleiterschicht (103) desselben Leitungstyps ausgebildet wird, der jedoch stärker dotiert ist.

10. Das Verfahren nach Anspruch 9, wobei das Verfahren ferner das Ausbilden einer Elektrode (107) aufweist, die einen ohmschen Kontakt mit der stärker dotierten Schicht (103) bildet.

11. Das Verfahren nach einem der Ansprüche 1 bis 10, wobei die Dicke der ersten leitenden Schicht, die im Schritt b) abgeschieden wurde, im Bereich von 20 bis 30 nm liegt.

## Claims

1. A method of manufacturing a Schottky diode, comprising the steps of:
a) oxygenating the surface of a single-crystal diamond semiconductor layer (105), to replace hydrogen surface terminations of the semiconductor layer (105) with oxygen surface terminations; and
b) forming, by physical vapor deposition, a first indium tin oxide conductive layer at the surface of the semiconductor layer (105).

2. The method of claim 1, wherein at step a), the semiconductor layer (105) is placed in an enclosure containing oxygen at a pressure lower than the atmospheric pressure, and is irradiated with ultraviolet light.

3. The method of claim 1 or 2, wherein the first conductive layer is formed, at step b), by sputtering of an indium tin oxide target.

4. The method of claim 3, wherein, at step b), the semiconductor layer (105) and the indium tin oxide target are placed in an enclosure containing an argon plasma.

5. The method of claim 3 or 4, further comprising, after step b), an anneal of recrystallization of the indium tin oxide layer at a temperature in the range from 100 to 300°C.

6. The method of any of claims 1 to 5, further comprising, after step b), depositing at least a second conductive layer at the surface of the first conductive layer, said conductive layers forming together an electrode (109) of the Schottky diode.

7. The method of claim 6, wherein said at least one second conductive layer comprises a gold layer.

8. The method of any of claims 1 to 7, wherein the semiconductor layer (105) is P-type doped.

9. The method of any of claims 1 to 8, wherein the semiconductor layer (105) is formed by epitaxy on a single-crystal diamond semiconductor layer (103) of the same conductivity type, but more heavily doped.

10. The method of claim 9, further comprising forming an electrode (107) forming an ohmic contact with said more heavily doped layer (103).

11. The method of any of claims 1 to 10, wherein the thickness of the first conductive layer deposited at step b) ranges from 20 to 30 nm.
